**Europäisches Patentamt**

**European Patent Office**

**Office européen des brevets**

(11) Veröffentlichungsnummer: **0 304 943**
**A2**

(12) **EUROPÄISCHE PATENTANMELDUNG**

(21) Anmeldenummer: **88113973.7**

(22) Anmeldetag: **26.08.88**

(51) Int. Cl.⁴: **H05K 13/08 , H05K 13/00**

(30) Priorität: **28.08.87 DE 3728818**

(43) Veröffentlichungstag der Anmeldung:
**01.03.89 Patentblatt 89/09**

(84) Benannte Vertragsstaaten:
**DE FR GB IT**

(71) Anmelder: **müt-GMBH**
**Freisinger Strasse 44**
**D-8061 Hebertshausen(DE)**

(72) Erfinder: **Stollner, Dieter**
**Freisinger Strasse 44**
**D-8061 Hebertshausen(DE)**

(74) Vertreter: **Prietsch, Reiner, Dipl.-Ing. et al**
**Patentanwälte Dipl.-Ing. Dipl. oec. publ. D.**
**Lewinsky, Dipl.-Ing. Reiner Prietsch**
**Gotthardstrasse 81**
**D-8000 München 21(DE)**

(54) **Vorrichtung zur Erzeugung von Lichtmarken auf einer elektrischen Baugruppe.**

(57) Eine Vorrichtung zur Erzeugung von Lichtmarken auf einer Baugruppe umfaßt einen Rechner (1) und eine, an diesen angeschlossene Projektionseinrichtung (2), die zwei von dem Rechner steuerbare Ablenkorgane enthält. Die Ablenkorgane richten den Lichtstrahl auf von dem Rechner vorgegebene Koordinatenpunkte auf der Baugruppe. An den Rechner (1) ist ein Baugruppentester (5) angeschlossen, der die Baugruppe (4) auf elektrische Fehler prüft. Der Rechner legt ermittelte Fehlerdaten in einem Fehlerdatenspeicher (1a) ab. Ein Positionsdatenspeicher (1b) enthält die Koordinaten aller theoretisch möglichen Fehlerorte der Baugruppe unter deren Adresse. Der Rechner ermittelt durch Vergleich die zu den Fehlerdaten gehörigen Positionsdaten und überträgt diese an die Projektionseinrichtung, die hieraus die Steuersignale für die Ablenkorgane erzeugt.

Fig. 1

EP 0 304 943 A2

## Vorrichtung zur Erzeugung von Lichtmarken auf einer elektrischen Baugruppe

Die Erfindung betrifft eine Vorrichtung der im Oberbegriff des Anspruches 1 angegebenen Art zur Erzeugung von Lichtmarken auf einer elektrischen Baugruppe.

Eine derartige Vorrichtung ist aus der DE-PS 27 51 651 bekannt. Sie dient zum Bestücken von gedruckten Schaltungen mit elektrischen Bauelementen und projiziert hierzu einen zwischen charakteristischen Punkten eines Bestückungsorts beweglichen Lichtpunkt auf die betreffende Leiterplatte. Hierbei ist offengelassen, in welcher Weise die elektrischen Signale zur Steuerung der Ablenkorgane erzeugt werden, jedoch ist es aus der DE-PS 27 16 548 für eine ähnliche Bestückungsvorrichtung bekannt, elektrische Signale für eine Positionieroptik mittels eines Rechners zu erzeugen, der eine Steuereinheit, einen Programmspeicher und eine Programmiereinheit umfaßt.

Die bekannte Vorrichtung ist allerdings nicht zum Reparieren von defekten Baugruppen geeignet. Während zur Fehlererkennung bereits EDV-gestützte Testsysteme, insbesondere Leiterplattentester zur Feststellung von Kurzschlüssen und Unterbrechungen der Leiterbahnen, In-Circuit-Tester zur Ermittlung von Bestückungsfehlern oder fehlerhaften Bauteilen und Funktionstester zur Überprüfung der Gesamtfunktion der bestückten elektrischen Baugruppe zur Verfügung stehen, erfolgt die Instandsetzung einer fehlerhaften Baugruppe anhand eines gedruckten oder auf einem Bildschirm angezeigten Fehlerprotokolls nach häufig zeitraubendem Suchen des Leiterbahnfehlers, des defekten Bauteiles oder des falsch bestückten Bauteiles. Diese Arbeit ist besonders bei SMD-bestückten Baugruppen mühevoll, zumal wenn häufig Baugruppen wechselnden Typs zu reparieren sind.

Aus der DE-OS 34 33 457 ist zwar auch schon eine Vorrichtung zum Markieren von Leiterplattenfehlern bekannt, die einen Rechner umfaßt, der mit einem Baugruppentester verbunden ist und nach einem Vergleich der übertragenen Fehlerdaten mit gespeicherten Positionsdaten die betreffende Fehlerposition auf der Baugruppe entweder dauerhaft oder mittels eines Lichtgriffels markiert. Die Reparatur der betreffenden Baugruppe erfolgt jedoch an anderer Stelle, so daß im Falle der Alternative einer vorübergehenden Markierung mittels Lichtgriffel diese manuell, z.B. durch Klebepunkte, in eine dauerhafte Kennzeichnung verwandelt werden muß, damit sie am Reparaturplatz wieder auffindbar ist. Bei den heute üblichen, hohen Bestückungsdichten ist dies äußerst mühselig, ebenso wie das anschließende Wiederauffinden der gekennzeichneten Positionen und die Durchführung der Reparatur, zumal wenn letztere das Austauschen von Bauelementen mitumfaßt.

Der Erfindung liegt die Aufgabe zugrunde, eine Vorrichtung der im Oberbegriff des Anspruches 1 angegebenen Art zu schaffen, die die sofortige Reparatur der jeweiligen Baugruppe nach selbsttätig erfolgender Fehlerortanzeige ermöglicht.

Diese Aufgabe ist erfindungsgemäß durch die im kennzeichnenden Teil des Anspruches 1 angegebenen Merkmale gelöst.

Der Vorteil dieser Lösung besteht darin, daß die jeweilige Baugruppe zur Reparatur in der Vorrichtung verbleiben kann, hiebei die Fehlerorte sequenziell markiert werden und stets das Magazinfach in Entnahmestellung präsentiert wird, welches das dem markierten Fehlerort entsprechende Bauteil enthält.

Die im Anspruch 2 angegebene Weiterbildung erspart es dem Reparateur, vor Beginn der Instandsetzung die die betreffende Baugruppe identifizierende Nummer in den Rechner einzugeben.

Die im Anspruch 3 genannte Ausführungsform macht sich den Umstand zu Nutze, daß im Falle des Vorhandenseins eines CAD-Systems alle interessierenden Positionsdaten bereits vorhanden sind, also nicht durch Editieren in den Positionsdatenspeicher der Vorrichtung nach der Erfindung eingespeichert werden müssen.

Die Vorrichtung nach der Erfindung kann zusätzlich auch zum Bestücken von Baugruppen bzw. von Leiterplatten benutzt werden, wenn gemäß Anspruch 4 ein Bestückungsdatenspeicher vorgesehen ist, in dem die Reihenfolge der Bestückung abgelegt ist.

Innerhalb der Vorrichtung nach der Erfindung kommt deren Projektionseinrichtung eine besondere Bedeutung für die Genauigkeit der Positionierung der Lichtmarke zu, wobei die Anforderungen naturgemäß umso höher sind, je feiner die Leiterbahnstrukturen und je größer die Packungsdichte der Bauteile ist.

Zu diesem Zweck ist gemäß Anspruch 5 eine Positionsregelung für das Ablenkmittel, beispielsweise einen durch ein Galvanometer angetriebenen Spiegel, jedes der beiden Ablenkorgane vorgesehen.

Ergänzend kann gemäß Anspruch 6 eine statische Nullpunkt-oder Referenzpunktkorrektur vorgesehen werden, die durch eine elektrische Drift oder durch mechanische Einflüsse, insbesondere temperaturabhängige Dehnungsvorgänge, ausgelöste Lageabweichungen der Lichtmarke kompensiert.

Eine bevorzugte Ausführungsform dieser Regelschaltung ist Gegenstand des Anspruches 7.

Der Anspruch 8 ist auf eine Weiterbildung gerichtet, mit der auch dynamische Fehler, z.B. Verstärkungsschwankungen der vorgeordneten Analogverstärker, ausgeglichen werden.

Es ist zweckmäßig, den oder die Referenzpunkte örtlich nicht der Projektionseinrichtung zuzuordnen, also sie z.B. im Bereich des Austritts des Lichtstrahles vorzusehen, sondern sie gemäß Anspruch 9 räumlich der Baugruppe zuzuordnen, weil dadurch einerseits eine höhere Auflösung und andererseits auch eine Kompensation von ungewollten mechanischen Lageverschiebungen zwischen der Projektionseinrichtung und der Halterung der Baugruppe kompensiert werden.

Hierbei ist zu berücksichtigen, daß bei manchen Baugruppen die Positioniergenauigkeit der Lichtmarken besser als 0,1 mm sein muß.

In der Zeichnung ist ein Ausführungsbeispiel nach der Erfindung schematisch vereinfacht dargestellt.

Es zeigt:

    Figur 1 ein Blockschaltbild

    Figur 2 eine blockschaltbildähnliche Darstellung der Projektionseinrichtung.

Da der prinzipielle mechanische Aufbau einer Vorrichtung der hier interessierenden Art dem Fachmann geläufig und z.B. aus der eingangs schon genannten DE-PS 27 51 651 bekannt ist, wird nachfolgend im wesentlichen nur deren elektrischer Aufbau beschrieben.

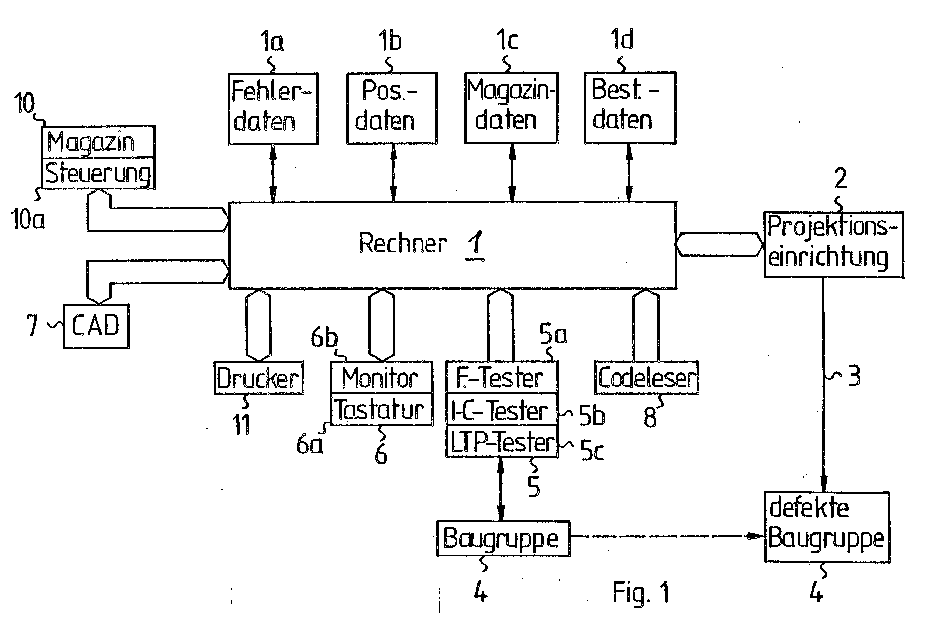

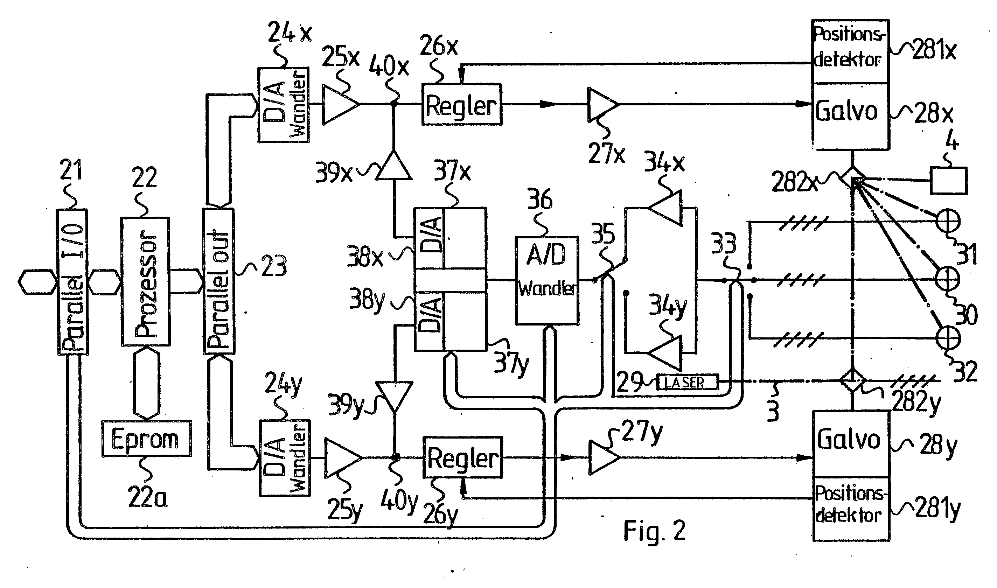

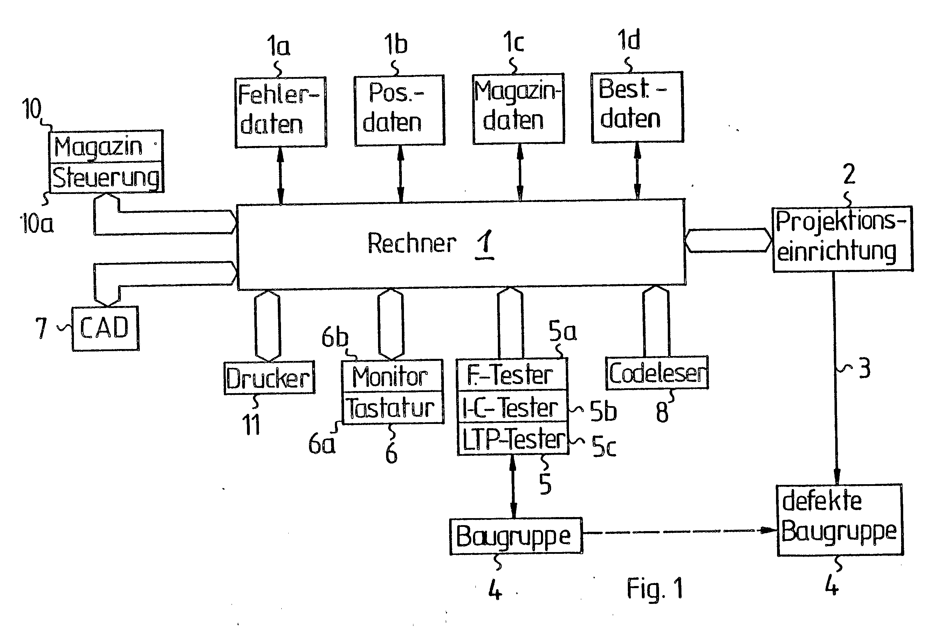

Die Vorrichtung umfaßt gemäß Figur 1 einen Rechner 1, der eine in Figur 2 näher dargestellte und später erläuterte Projektionseinrichtung 2 steuert, die einen Lichtstrahl 3, vorzugsweise einen Laserlichtstrahl, auf eine defekte Baugruppe 4 projiziert und dort an einer von dem Rechner 1 vorgegebenen Stelle eine Lichtmarke erzeugt. Die Projektionseinrichtung 2 befindet sich in einem nicht dargestellten Projektionskopf oberhalb einer ebenfalls nicht dargestellten Halterung, in der die defekte Baugruppe 4 positioniert in bezug auf zwei Referenzrichtungen, z.B. die Achsen eines kartesischen x,y-Koordinatensystems aufgenommen ist.

Der oder die Defekt(e) der Baugruppe wurden zuvor durch ein üblicherweise räumlich getrennt von der vorliegenden Vorrichtung angeordnetes Testsystem 5 ermittelt, das je nach Art der zu prüfenden Baugruppe einen Funktionstester 5a, einen ICT-Tester 5b oder auch nur einen Leiterplattentester 5c umfassen kann, jedenfalls aber die ermittelten Fehlerdaten, die sich auf bestimmte Bauteile, bestimmte Leiterbahnen oder auch nur auf zwischen vorgegebenen Testpunkten liegende Leiterbahnabschnitte beziehen können, an den Rechner 1 zusammen mit der Identifikationsnummer der betreffenden Baugruppe überträgt. Der Rechner 1 legt diese Fehlerdaten in einem Fehlerdatenspeicher 1a ab. In einem Positionsdatenspeicher 1b sind die Koordinaten der Leiterbahnen und/oder der Testpunkte und/oder der Bauelemente unter der Adresse der betreffenden Baugruppe abgelegt. Diese Positionsdaten können entweder über ein Terminal 6, das eine Tastatur 6a und einen Monitor 6b umfaßt, eingegeben werden, oder auch von einem üblichen und nur schematisch angedeuteten CAD-System 7 übernommen werden.

Sobald nun die Identifikationsnummer der defekten Baugruppe 4 entweder über die Tastatur 6a des Terminals 6 oder vorzugsweise über einen Codeleser 7, vorzugsweise einen BAR-Codeleser, in den Rechner 1 eingegeben und das Reparaturprogramm aufgerufen ist, vergleicht der Rechner 1 die Fehlerdaten mit den Positionsdaten und steuert die Projektionseinrichtung 2 so, daß deren Lichtstrahl 3 den Ort des ersten Fehlers auf der Baugruppe 4 markiert. Die Markierung kann je nach Art des Fehlers punktförmig (Beispiel: fehlerhafte Lötstelle) oder strichförmig (Beispiel: fehlende Drahtbrücke) sein, aber auch eine geschlossene Fläche oder deren Umriß bilden (Beispiel: defektes IC). Die Erzeugung solcher Markierungsfiguren ist an sich bekannt und wird daher hier nicht näher erläutert.

Sofern der Fehler durch Austausch eines Bauelementes behoben werden muß, fragt der Rechner 1 gleichzeitig aus einem Magazindatenspeicher 1c den Lagerort des betreffenden Bauteiles ab und übermittelt diese Adresse in digitaler Form an die elektrische Steuerung 10a eines Paternostermagazins 10. Das Paternostermagazin 10 präsentiert daraufhin dem Reparateur das Magazinfach mit dem betreffenden benötigten Bauelement.

Nach Abschluß der Reparatur quittiert der Reparateur diese über die Tastatur 6a. Daraufhin wiederholt sich der gleiche Vorgang für den nächsten Fehler.

Über die Tastatur 6a kann der Reparateur auch eine an der einen oder der anderen Koordinatenrichtung gespiegelte Markierung des jeweiligen Fehlerortes veranlassen. Die normale Markierung dient dann zur Ermittlung des defekten Bauelementes auf der Bestückungsseite der Baugruppe, die gespiegelte Markierung zum Auffinden der zugehörigen Lötpunkte auf der Leiterbahnseite der Baugruppe. Ferner kann der Reparateur über die Tastatur 6a auch die Reihenfolge, in der die einzelnen Fehler angezeigt werden, bestimmen, da es oft zweckmäßig ist, gleichartige Fehler oder gleichartige Bauteile betreffende Fehler nacheinander zu beheben. Alle Fehler können auf dem Monitor 6b zur Anzeige gebracht oder auch über einen Drucker 11 in geeigneter Form, z.B. auch statistisch ausgewertet, ausgedruckt werden. Sofern die Vorrichtung zum Bestücken statt zum Reparieren von Baugruppen verwendet werden soll, genügt es, sie um einen Bestückungsdatenspeicher 1d zu ergänzen, in dem die zweckmäßige Reihenfolge der Bestückung der Leiterplatte mit den Bauelementen abgelegt ist.

Die in Figur 2 näher dargestellte Projektionseinrichtung umfaßt eine Schnittstelle 21 zum Datenaustausch mit dem Rechner 1 in Figur 1, einen Prozessor 22, in dessen EPROM-Speicher 22a ein Betriebsprogramm abgelegt ist, mittels dessen beispielsweise die verschiedenen, bereits erwähnten Markierungsarten generiert werden, sowie eine Ausgabeeinheit 23, die die digitalen Koordinatendaten in der hier gewählten x,y-Darstellung getrennt an einen D/A-Wandler 24x für die x-Koordinate und an einen D/A-Wandler 24y für die y-Koordinate ausgibt. Die von den beiden D/A-Wandlern erzeugten Analogsignale werden über Pufferverstärker 25x und 25y als Sollwerte je einem Regler 26x und 26y zugeführt, die über Treiberverstärker 27x und 27y die jeweilige Stellgröße Spiegelgalvanometern 28x bzw. 28y zuführen, die mit Positionsdetektoren 281x bzw. 281y ausgestattet sind, welche den jeweiligen IST-Wert liefern, der wiederum dem jeweiligen Regler 26x bzw. 26y zugeführt wird, so daß sich eine geschlossene Regelschleife ergibt. Die Galvanometer betätigen jeweils einen sehr kleinen Spiegel 282x bzw. 282 y. Die Spiegel liegen im Strahlengang einer Laserlichtquelle 29, die den Lichtstrahl 3 erzeugt.

Der abgelenkte Lichtstrahl 3 kann statt auf eine bestimmte Stelle der hier nur angedeuteten, defekten Baugruppe 4 auf bestimmte Referenzpunkte gerichtet werden, die räumlich etwa in Höhe der Baugruppe 4, also z.B. auf dem mit der Halterung für die Baugruppe versehenen Tisch angeordnet sind. In jedem dieser drei Referenzpunkte befindet sich eine Vier-Quadranten-Fotodetektor 30, 31, 32, aus dessen vier Ausgangssignalen sich die Ablage des Lichtstrahles 3 vom Zentrum des jeweiligen Fotodetektors nach Richtung und Betrag in bekannter Weise durch Bildung der Summe und der Differenz dieser vier Ausgangssignale ermitteln läßt. Hierbei dient der Fotodetektor 30 zur Feststellung einer Nullpunkt-Ablage, der von dem Fotodetektor 30 eine vorgegebene Strecke in x-Richtung entfernte Fotodektor 31 zur Feststellung einer Drift im x-Zweig der Projektionsvorrichtung und der von dem Fotodetektor 30 eine vorgegebene Strecke in y-Richtung entfernte Fotodetektor 32 zur Feststellung einer Drift im y-Zweig der Projektionsvorrichtung.

In einem bestimmten, von dem Rechner 1 in Figur 1 vorgegebenen Zeittakt werden die Fotodetektoren 30, 31 und 32 mittels eines symbolisch dargestellten, mehrpoligen Schalters 33 abgefragt und hierzu über diesen Schalter mit den Eingängen von Operationsverstärkern 34x bzw. 34y verbunden, deren Ausgänge über einen weiteren nur symbolisch dargestellten Schalter 35 mit dem Eingang eines gemeinsamen A/D-Wandlers 36 verbunden sind, der die ermittelten Abfragewerte in digitaler Form an je einen Speicher 37x bzw. 37y liefert.

Die gespeicherten Werte werden mittels D/A-Wandlern 38x bzw. 38y in Analogsignale zurückverwandelt und über Verstärker 39x bzw. 39y in den Summationspunkten 40x bzw. 40y als Korrekturwerte den von den Vorverstärkern 25x bzw. 25y abgegebenen Sollwerten hinzuaddiert. Auf diese Weise wird eine statische Nullpunktdrift ausgeregelt bzw. kompensiert, so daß Positionierungsgenauigkeiten von besser als 0,1 mm reproduzierbar erhalten werden. Zur Kompensation einer dynamischen Drift der Positionierung des Lichtstrahls werden die digitalisierten Abfragewerte von dem A/D-Wandler 36 über die Bus-Verbindung an den Rechner 1 übertragen, der hieraus Korrekturwerte für die x- und y-Sollwerte errechnet. Da die Ermittlung der Korrekturwerte sehr rasch von statten geht, können die den Referenzpunkten entsprechenden Fotodetektoren 30, 31 und 32 wahlweise vor jeder neuen Fehlerortmarkierung oder auch periodisch abgefragt werden. Die Koordinaten der Referenzpunkte können in dem EPROM-Speicher 22a abgelegt werden. Der Aufruf wie auch die Steuerung der Schaltungsteile 33, 35, 36 und 37 erfolgt über den Rechner 1.

## Ansprüche

1. Vorrichtung zur Erzeugung von Lichtmarken auf einer elektrischen Baugruppe (4) mittels einer an einen Rechner (1) angeschlossenen Projektionseinrichtung (2), die eine Lichtquelle (29), eine Optik zur Fokussierung des Lichtstrahles sowie zwei elektrisch steuerbare Ablenkorgane für den Lichtstrahl (3) umfaßt und diesen auf von dem Rechner vorgegebene Koordinatenpunkte auf der in einer Halterung positioniert in bezug auf zwei Referenzrichtungen aufgenommenen Baugruppe (4) richtet, dadurch gekennzeichnet, daß an den Rechner (1) ein Baugruppentester (5) angeschlossen ist, der die Baugruppe (4) auf elektrische Fehler prüft und ermittelte Fehler als digitale Information an den Rechner (1) überträgt, daß der Rechner (1) einen Fehlerdatenspeicher (1a), in dem er die übertragenen Fehlerdaten unter der Adresse der geprüften Baugruppe ablegt, sowie einen Positionsdatenspeicher (1b), in dem die Koordinaten von Leiterbahnen, Bauelementen, Testpunkten oder anderer zu markierender Stellen der betreffenden Baugruppe unter deren Adresse abgelegt sind, umfaßt, sowie die zu den Fehlerdaten gehörigen Positionsdaten durch Vergleich ermittelt und die ermittelten Positionsdaten sequentiell an die Projektionseinrichtung (2) übermittelt, und daß der Rechner (1) einen Ersatzteil-Magazindatenspeicher (1c) umfaßt, in dem die Lagerdaten von Ersatzbauteilen abgelegt sind, die in einem einen Bestandteil der Vorrichtung bildenden Paternostermagazin (10) vorrätig gehalten sind, dessen elektrische Steuerung (10a) an den Rechner (1) angeschlossen ist.

2. Vorrichtung nach Anspruch 1, dadurch gekennzeichnet, daß an den Rechner (1) ein Codeleser (8) zur Eingabe eines die Baugruppe (4) identifizierenden, auf dieser angebrachten Codes angeschlossen ist.

3. Vorrichtung nach Anspruch 1 oder 2, dadurch gekennzeichnet, daß der REchner (1) eine Schnittstelle zur Verbindung mit einem CAD-System (7) hat.

4. Vorrichtung nach einem der Ansprüche 1 bis 3, dadurch gekennzeichnet, daß der Rechner (1) einen Bestückungsdatenspeicher (1d) umfaßt, in dem die Bestückungsreihenfolge der Bauteile abgelegt ist.

5. Vorrichtung nach einem der Ansprüche 1 bis 4, dadurch gekennzeichnet, daß die Projektionseinrichtung (2) je eine Nachführschaltung (281x, 26x; 281y, 26y) zur Positionsregelung des Ablenkmittels (28x, 28y) jedes Ablenkorgans hat.

6. Vorrichtung nach einem der Ansprüche 1 bis 5, dadurch gekennzeichnet, daß die Projektionseinrichtung (2) eine von dem Rechner (1) gesteuerte Regelschaltung (33 bis 39) zur Kompensation der statischen Drift des Lichtstrahles in bezug auf einen mechanischen Referenzpunkt (30) hat.

7. Vorrichtung nach Anspruch 6, dadurch gekennzeichnet, daß in dem mechanischen Referenzpunkt ein Fotodetektor (30) angeordnet ist, dessen Ausgangssignale nach Vorzeichen und Amplitude ein Maß für die Ablage des Lichtstrahles (3) von dem Referenzounkt darstellen, und daß die Regelschaltung (33 bis 39) für jedes Ablenkorgan ein statisches Korrektursignal erzeugt, das die statische, elektrische und mechanische Drift des Lichtstrahles in der diesem Ablenkorgan entsprechenden Koordinate (x, y) kompensiert.

8. Vorrichtung nach Anspruch 7, dadurch gekennzeichnet, daß für jede Koordinate in einem weiteren, von dem ersten mechanischen Referenzpunkt beabstandeten Referenzpunkt ein weiterer Fotodetektor (31, 32) angeordnet ist, dessen Ausgangssignale nach Vorzeichen und Amplitude ein Maß für die Ablage des Lichtstrahles von dem weiteren Referenzpunkt darstellen, und daß die Regelschaltung (33 bis 39) für jedes Ablenkorgan ein weiteres Korrektursignal erzeugt, das die dynamische Drift des entsprechenden Ablenkorgans kompensiert.

9. Vorrichtung nach einem der Ansprüche 6 bis 8, dadurch gekennzeichnet, daß der (die) Referenzpunkt(e) (30, 31, 32) im Bereich der Halterung der Baugruppe (4) angeordnet sind.

Fig. 1

Fig. 2

Fig. 1

EP 0 304 943 A2